# EUROPÄISCHE PATENTSCHRIFT

(11) **EP 0 762 501 B1**
(45) Veröffentlichungstag und Bekanntmachung des Hinweises auf die Patenterteilung: **14.03.2001**
(21) Anmeldenummer: 96113672.8
(22) Anmeldetag: 27.08.1996
(51) Int. Cl.: H01L 27/06, H01L 21/8252, H01L 29/868

(54) **Monolithisch integrierte Anordnung von PIN-Diode und Feldeffekttransistor und Verfahren zu deren Herstellung**
Monolithic integrated device of PIN diode and field effect transistor and method of manufacturing the same
Dispositif intégré monolithique de diode PIN et transistor à effet de champ, et méthode de fabrication

(30) Priorität: 08.09.1995 DE 19533205
(43) Veröffentlichungstag der Anmeldung: 12.03.1997
(73) Patentinhaber: DaimlerChrysler AG, 70567 Stuttgart (DE)
(72) Erfinder: Brugger, Hans, Dr., 89250 Senden (DE)
(74) Vertreter: Fröhling, Werner Otto, Dr.

(56) Entgegenhaltungen:
- MICROELECTRONIC ENGINEERING, Bd. 15, Nr. 1 / 04, 1.Oktober 1991, Seiten 275-278, XP000292766 HURM V ET AL: "10 GBIT/S MONOLITHIC INTEGRATED OPTOELECTRONIC RECEIVER USING AN MSM PHOTODIODE AND ALGAAS/GAAS HEMTS"
- MICROWAVE AND MILLIMETER WAVE MONOLITHIC CIRCUITS SYMPOSIUM, NEW YORK, MAY 24 - 25, 1988, Nr. 1988, 24.Mai 1988, DAWSON D E, Seiten 147-150, XP000043056 SEYMOUR D J ET AL: "X-BAND AND KA-BAND MONOLITHIC GAAS PIN DIODE VARIABLE ATTENUATION LIMITERS"
- IEEE MTT-S INTERNATIONAL MICROWAVE SYMPOSIUM DIGEST, ORLANDO, MAY 16 - 20, 1995, Bd. 3, 16.Mai 1995, KIRBY L (ED ), Seiten 1631-1634, XP000553005 KLAASSEN A ET AL: "77 GHZ MONOLITYHIC MMIC SCHOTTKY- AND PIN-DIODE SWITCHES BASED ON GAAS MESFET AND SILICON SIMMWIC TECHNOLOGY"

## Beschreibung

Die Erfindung betrifft eine monolithisch integrierte Anordnung aus PIN-Diode und Feldeffekttransistor und ein Verfahren zu deren Herstellung.

In Kommunikations-, Sensorik- und Radarsystemen, sowie in der Radar- und Satellitentechnik werden bipolare PIN-Dioden und Feldeffekttransistoren (FET) in Form von Metall-Halbleiter-FETs (MESFETs) oder, mit zunehmend weiterer Erhöhung der Arbeitsfrequenzen in den Millimeterwellenbereich, auch neuartige Heterostruktur-FETs (HFETs) mit einem zweidimensionalen Elektronengaskanal (2DEG) eingesetzt. PIN-Dioden werden für schnelle Schalteranwendungen zur Strahlsteuerung eingesetzt und als gesteuerte Hochfrequenz (HF) Dämpfungsglieder verwendet. Ferner dienen PIN-Elemente als schnelle Begrenzer-/Schutzdioden für empfindliche Empfängerschaltkreise, um die rauscharmen Vorverstärker vor hohen Hochfrequenz (HF) Signalen zu schützen. FETs finden eine breite Anwendung als aktive Elemente zur HF-Signalerzeugung in Oszillatoren (z.B. als VCO), als rauscharmer Verstärker, als Leistungsverstärker und als aktive Mischer mit Konversionsgewinn. Für Schalteranwendungen sind jedoch FET-Bauelemente wegen der großen Einfügungsdämpfung und dem begrenzten Isolationsverhalten den PIN-Dioden deutlich unterlegen. Einer monolithischen Integration der beiden Schlüsselbauelemente PIN-Diode/MESFET und PIN-Diode/HEFT kommt deshalb besondere Bedeutung.

Mit einer monolithisch integrierten Bauelementanordnung lassen sich die für ein HF-Frontend erforderliche Anzahl der Chips reduzieren, die Funktionalität eines Millimeterwellen-ICs (MMIC) in vorteilhafterweise erhöhen und der HF-Systemteil kompakter realisieren. Dies führt zu einer insgesamt wirtschaftlicheren Gesamtlösung eines HF-Frontends, da der Aufwand an hybrider Montage- und Aufbautechnik reduziert wird und die Herstellungskosten gesenkt werden können. Ferner werden parasitäre Verluste, insbesondere an den Schnittstellen hybrider Komponenten, minimiert und dadurch die für das System erforderliche HF-Leistung in vorteilhafterweise reduziert.

Für die technologische Fertigung von elektronischen Bauelementen für hohe Arbeitsfrequenzen (HF-Bauelemente) werden Halbleiterausgangsmaterialien verwendet, die mit epitaktischen Wachstumsmethoden (z. B. Molekularstrahlepitaxie, MBE, Metallorganische Gasphasenepitaxie, MOCVD) hergestellt werden. Durch die Epitaxie werden auf einem Substrat unterschiedliche, die Funktion des Bauelements bestimmende Schichten, abgeschieden und mit lithographischen Verfahren (Photo- und Elektronenstrahllithographie) und mit Ätzprozeßen (naß- und trockenchemische Verfahren) strukturiert.

Aus einer Veröffentlichung von P. Huang et al. in IEEE MTT-S Digest 1995, S. 205-206 ist eine integrierte Anordnung von GaAs HFETs mit GaAs PIN-Dioden bekannt, die eine nicht-planare Struktur mit einer hohen, vertikalen PIN-Diode (Mesastruktur) aufweist. Der HFET wird durch einen zusätzlichen Epitaxieprozeß in Form eines selektiven Wachstums hergestellt und ist in einem Bereich lokalisiert, an dem zuvor die PIN-Schichtenfolge entfernt wurde. Der insgesamte aufwand für die Scheibenherstellung und Prozeßtechnologie ist sehr zeitintensiv und teuer.

Eine Veröffentlichung von P. Seymour et al. in Microwave and Millimeter-Wave Monolithic Circuits Symposium 1988, s. 147-150, betrifft eine PIN-Diode mit lateral angeordneten P- und N-Bereichen in einem undotierten GaAs-Substrat. Dabei wird die Möglichkeit der Verwendung des Si-Implantats zur FET Herstellung im gleichen Schaltkreis erwähnt, jedoch nicht näher erläutert.
Der Erfindung liegt die Aufgabe zugrunde, einen integrierten Schaltkreis für den Millimeterwellenbereich und ein Verfahren zu deren Herstellung anzugeben, dessen Anordnung der Halbleiterbauelemente eine vereinfachte technische Herstellung ermöglicht. Die Aufgabe wird gelöst durch die im kennzeichnenden Teil der Patentansprüche 1 und 5 angegebenen Merkmale. Vorteilhafte Ausgestaltungen und/oder Weiterbildungen sind den Unteransprüchen zu entnehmen.

Ein Vorteil der Erfindung besteht in der Kombination von MESFET und PIN-Diode bzw. HFET und PIN-Diode in integrierter Bauweise, da dadurch parasitäre Verluste, insbesondere an den Verbindungsstellen der Bauelemente, minimiert werden. Durch den erfindungsgemäßen Schichtaufbau für den integrierten Schaltkreis lassen sich die Diode und der Transistor unabhängig voneinander auf die gewünschten Eigenschaften optimieren.

Weiterhin ist vorteilhaft, daß für die Realisierung der PIN-Diode eine undotierte GaAs-Schicht unterhalb des stromführenden Kanals im Transistor verwendet wird. Im Transistor dient diese undotierte GaAs-Schicht zusätzlich als Pufferschicht. Es ist nur ein Epitaxieprozeß für die Herstellung der Halbleiterschichtenfolge für PIN-Diode und Feldeffekttransistor notwendig. Weiterhin ist vorteilhaft, daß durch die quasi-planare Anordnung von Diode und Transistor eine vereinfachte und teilweise parallele Herstellung der Kontaktbereiche für beide Bauelemente in technologisch kompatibler Weise ermöglicht wird.

Als Transistorbauelemente kommen MESFETs auf GaAs-Basis mit einem für den jeweiligen Einsatz optimierten Dotierstoffprofil in Frage. Ferner kommen als Transistorbauelemente HFETs auf GaAs-Substraten in Form von gitterangepaßten, einseitig oder doppelseitig dotierten Heterostrukturen mit einem zweidimensionalen Elektronengas in Frage. Als Heterostrukturen werden beispielsweise GaAs/AlGaAsInGaAs/AlGaAs/GaAs-, InGaAs/InGaP- oder InGaAS/AlGaAs/InGaP-Materialkombinationen verwendet.

Mit der vorgeschlagenen Technologie lassen sich HFET-Bauelemente mit Grenzfrequenzen deutlich über 200 GHz und PIN-Dioden für hohe HF-Signalleistungen mit Schaltzeiten im Nanosekunden-Bereich realisieren. Mit dem vorgeschlagenen Verfahren und der vorteilhaften, monolithischen Bauelementanordnung lassen sich HF-Komponenten mit unterschiedlichen Funktionseinheiten in kompakter Form monolithisch integrieren und dadurch die Chipzahl der HF-Frontends in vorteilhafterweise reduzieren. Beispielsweise ist eine Kombination aus FET für die HF-Leistungserzeugung und -verstärkung, sowie ein empfindlicher Signalempfänger mit rauscharmen FET-Vorverstärker und aktivem FET-Mischer, kombinierbar mit PIN-Dioden für die Strahlsteuerung innerhalb des T/R-Moduls (Sende-/Empfangspfadumschaltung) und die Strahlsteuerung zu verschiedenen Antennenausgängen und -eingängen realisierbar.

Die Erfindung wird anhand eines Ausführungsbeispiels und unter Bezugnahme auf schematische Zeichnungen näher erläutert.

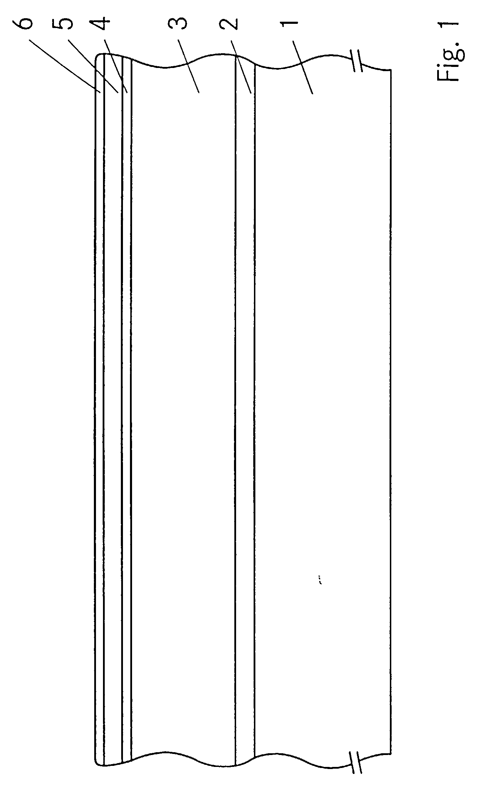

In Fig. 1 ist der Halbleiterschichtaufbau für die integrierte Bauelementanordnung dargestellt. Als Substrat wird eine halbisolierende GaAs-Scheibe 1 verwendet. Mit Hilfe einer Epitaxiemethode, vorzugsweise Molekularstrahlepitaxie (MBE), wird zuerst eine Pufferschicht aus undotiertem GaAs-Material und AlGaAs/GaAs-Übergitter hergestellt. Danach wird die Halbleiterschichtenfolge für die beiden Bauelemente abgeschieden:
- eine undotierte GaAs-Schicht 3 für das PIN-Diodenbauelement mit einer beispielhaften Dicke im Bereich zwischen 0,4 µm und 0,8 µm
- eine Schichtenfolge 4, 5, 6 für den Feldeffekttransistor.

Wird der Feldeffekttransistor als HFET ausgebildet, besteht die Schichtenfolge z.B. aus
- einer undotierten In_{0,2} Ga_{0,8} As-Schicht 4 mit einer Schichtdicke von 12 nm; diese Schicht bildet den Potentialtopf für das zweidimensionale Elektronengas,
- einer homogenen-,puls-oder delta-n-dotierten Al_{0,2} Ga_{0,8} As-Schicht 5 mit einer Dotierkonzentration von 5x10¹² cm⁻² und einer Schichtdicke von 30 nm, und
- einer homogenen n-dotierten GaAs-Schicht 6 mit einer Dotierkonzentration von 5x10¹⁸ cm⁻³ und einer Schichtdicke von 40 nm; diese Schicht bildet die Deckschicht für die niederohmigen Kontakte.

Vorteilhafterweise wird zwischen der Schicht 4 und 5 eine undotierte Spacerschicht aus z.B. GaAs/AlGaAs mit einer Dicke von 5 µm eingebracht. Zusätzlich kann zwischen Schicht 5 und 6 eine undotierte Ätzstopschicht aus einer 5 nm dicken Ga_{0,5}In_{0,5}P- oder einer 3 nm dicken AlAs-Schicht eingebaut werden.
Wird ein MESFET ausgebildet besteht die Schicht 4 und 5 z.B. aus homogen n-dotiertem GaAs mit einer Dotierkonzentration von 3x10¹⁷ cm⁻³ und einer Schichtdicke von 150 nm.

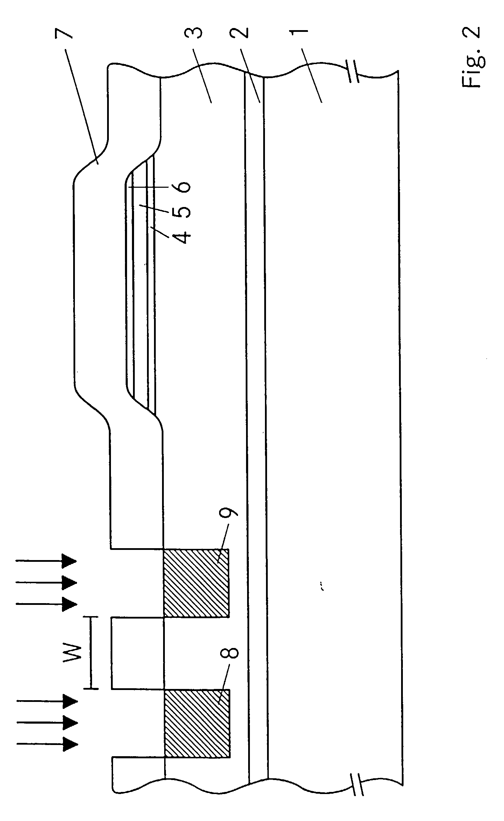

Die Bauelementherstellung erfolgt nach den folgenden Schritten: Mit photolithographischen Verfahren und einem Ätzprozeß werden die Schichten 4, 5 und 6 wieder abgetragen, derart, daß überall dort, wo ein FET-Bauelement realisiert werden soll, eine Mesastruktur mit der kompletten Schichtenfolge 1 bis 6 erhalten bleibt. Dies ist in Fig. 2 schematisch dargestellt.

Die Halbleiterscheibe wird in einem weiteren Technologieschritt mit einer Schicht 7 vorzugsweise einer dielektrischen Schicht, beispielsweise Si₃N₄ oder SiO₂, versehen. Mit einem photolithographischen Verfahren werden Fenster geöffnet, deren laterale Position die N und P-Kontaktbereiche der PIN-Diode definieren. Die hergestellte Maske dient als Implantationsmaske für eine selektive Dotierimplantation mit donatorartigen Ionen zur Realisierung der N-Kontaktbereiche. Für die Realisierung der P-Implantation wird der Prozeß wiederholt.

Als Ionen für die N-Bereiche verwendet man beispielsweise Siliziumionen (Si⁺) mit einer beispielhaften Gesamtdosis von 2x10¹⁴cm⁻² mit typischerweise 320 keV (1,5x10¹⁴cm⁻²), 120 keV (4x10¹³cm⁻²) und 40 keV (1,5x10¹³cm⁻²). Als Ionen für die P-Bereiche verwendet man beispielsweise Magnesiumionen (Mg⁺) mit einer beispielhaften Gesamtdosis von über 10¹⁵cm⁻². Die Energieabstufungen und relativen Dosisverhältnisse sind ähnlich wie bei der Si-Implantation, da die Atommassen der beiden Elemente ähnlich sind. Die erreichbaren Ladungsträgerdichten sind typischerweise über 3x10¹⁸cm⁻³ für die N-Bereiche und über 5x10¹⁹cm⁻³ für die P-Bereiche.

Generell sind andere Ionensorten für die P- und N-Kontaktbereiche verwendbar, etwa Be, C, S, Se, etc. Die Energien und die relativen Dosisverhältnisse sind dann so aufeinander abgestimmt, daß die Tiefenprofile der P- und N-Ionenverteilung möglichst gleich sind. Durch höhere Ionenenergien und Ionendosen läßt sich die Tiefe der Kontaktbereiche insgesamt vergrößern und die Leitfähigkeit erhöhen, was sich vorteilhaft auf den Serienwiderstand der PIN-Diode auswirkt.

In einem weiteren Schritt wird die Halbleiterscheibe mit einer dielektrischen Schicht versehen, beispielsweise SiON oder SiO₂, und ein Kurzzeitausheilschritt bei Temperaturen, beispielsweise im Bereich zwischen 800°C und 900°C durchgeführt. Die maximale Ausheiltemperatur wird so gewählt, daß die Schichtenfolge 4 bis 6 thermisch nicht zerstört wird, insbesondere keine signifikante Verschmierung des Dotierstoffprofils in der Schicht 5 eintritt bzw. zwischen den Schichten 4 und 5 bzw. 5 und 6. Die HFET-Bauelemente mit Heterostrukturen, insbesondere mit pseudomorphen Potentialtopfschichten (z.B. InGaAs), sind dabei temperaturempfindlicher als reine GaAs MESFETs. Der I-Bereich mit der Weite W ist durch den Abstand der P- und N-Kontaktbereiche definiert und bestimmt wesentlich die Sperrspannung der PIN-Diode.

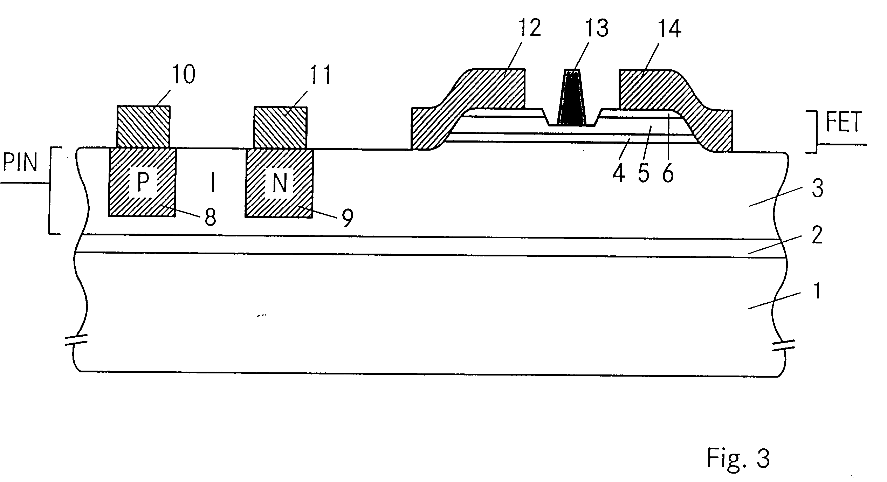

Die Kontaktmetallisierungen werden durch Einsatz von photolithographischen Verfahren und konventionellen Aufdampftechniken hergestellt. Dies ist schematisch in Fig. 3 dargestellt. Dabei können die ohmschen Kontakte 11 für die N-leitenden Kontaktbereiche der PIN-Diode zusammen mit den ohmschen Source- und Drain- Kontakten 12,14 des FET-Bauelements hergestellt werden, beispielsweise mit einer Metallisierungsschichtenfolge Ge/Ni/Au. Der ohmsche P-Kontakt 10 der PIN-Diode wird entsprechend hergestellt, beispielsweise mit einer Metallisierungsschichtenfolge Ti/Pt/Au. Durch einen Kurzzeitausheilschritt, beispielsweise bei ca. 400°C erfolgt die Legierung sämtlicher ohmscher Kontakte der Bauelementanordnung. Der FET Gate-Schottkykontakt 13 wird mit Hilfe einer lithographischen Technik definiert (z.B. mit Steppertechnik) oder bei sehr kleinen Gatedimensionen durch den Einsatz einer Elektronenstrahllithographie realisiert.

## Patentansprüche

1. Integrierte Anordnung von PIN-Diode und Feldeffekttransistor, dadurch gekennzeichnet,
- daß der Feldeffekttransistor aus III/V-Halbleitermaterial als HFET oder MESFET ausgebildet ist,
- daß die PIN-Diode in einer undotierten Halbleiterschicht aus lll/V-Halbleitermaterial mit lateralen P-, 1-, N-Bereichen aufgebaut ist, und
- daß PIN-Diode und Feldeffekttransistor lateral angeordnet sind, derart, daß die undotierte Halbleiterschicht der Diode eine zusätzliche Pufferschicht der Transistorstruktur bildet.

2. Integrierte Anordnung nach Anspruch 1, dadurch gekennzeichnet,
- daß PIN-Diode und Feldeffekttransistor auf einem halbisolierenden GaAs-Substrat (1) und einer darauf aufgebrachten Pufferschicht (2) aus GaAs und einen AlGaAs/GaAs Übergitter angeordnet sind,
- daß auf die Pufferschicht (2) eine undotierte GaAs-Schicht (3) aufgebracht ist,
- daß die PIN-Diode in der undotierten GaAs-Schicht (3) durch implantierte P- und N-Kontaktbereiche (8, 9) enthält gebildet ist,
- daß auf die undotierte GaAs-Schicht (3), die eine zusätzliche Pufferschicht für den Transistor bildet, die aktiven Halbleiterschichten (4, 5, 6) des Feldeffekttransistors derart angeordnet sind, daß lediglich im Bereich des Feldeffekttransistors die aktiven Halbleiterschichten (4, 5, 6) des Transistors erhalten sind.

3. Integrierte Anordnung nach Anspruch 2, dadurch gekennzeichnet, daß der Feldeffekttransistor als HFET ausgebildet ist und aus einer Schichtenfolge aus
- einer undotierten InGaAs-Schicht (4) mit einer Schichtdicke von ca. 12nm,
- einer undotierten GaAs/AlGaAs-Spacerschicht mit einer Schichtdicke von ca 5 nm,
- einer homogen-, puls- oder delta-n-dotierten AlGaAs-Schicht (5) mit einer Dotierkonzentration von 5x10¹² cm⁻³ und einer Schichtdicke von etwa 30nm, und
- einer homogen n-dotierten GaAs-Schicht (6) mit einer Dotierkonzentration von 5x10¹⁸ cm⁻³ und einer Schichtdicke von etwa 40nm besteht.

4. Integrierte Anordnung nach Anspruch 2, dadurch gekennzeichnet, daß der Feldeffekttransistor als MESFET ausgebildet ist und aus einer Schichtenfolge aus
- einer homogen n-dotierten GaAs-Schicht (4) mit einer Dotierkonzentration von 3x10¹⁷ cm⁻³ einer Schichtdicke von 100 nm
- einer homogen n-dotierten GaAs-Schicht (5) mit einer Dotierkonzentration von 3x10¹⁷ cm⁻³ und einer Schichtdicke von 50 nm
- einer homogen n-dotierten GaAs-Schicht (6) mit einer Dotierkonzentration 5x10¹⁸ cm⁻³ und einer Schichtdicke von etwa 40nm besteht.

5. Verfahren zur Herstellung einer integrierten Anordnung aus PIN-Diode und Feldeffekttransistor nach einem der vorherigen Ansprüche 2, 3 oder 4, dadurch gekennzeichnet,
- daß auf einem halbisolierenden Substrat (1) die Pufferschicht (2), die undotierte GaAs-Schicht (3) und die aktiven Halbleiterschichten (4, 5 ,6 )des Transistors in lediglich einem Epitaxieprozeß aufgewachsen werden,
- daß die aktiven Halbleiterschichten (4, 5, 6) des Transistors im Bereich der PIN-Diode entfernt werden,
- daß eine dielektrische Schicht (7) auf die Oberfläche der Anordnung aufgebracht wird und derart strukturiert wird, daß eine Maske für die Herstellung der N- und P- Kontaktbereiche der PIN-Diode ausgebildet wird,
- daß in der Schicht (3) die N- und P-Kontaktbereiche (8, 9) implantiert werden und anschließend ein Ausheilprozeß durchgeführt, und
- daß die Kontakte für die PIN-Diode und den Feldeffekttransistor hergestellt werden und zumindest die ohmschen Kontakte für den N-leitenden Kontaktbereich (11) der PIN-Diode gleichzeitig mit den ohmschen Source- und Drainkontakten (12, 14) aufgebracht werden.

## Claims

1. Integrated arrangement of PIN diode and field effect transistor, characterised in that
- the field effect transistor is formed from IIIN semiconductor material as HFET or MESFET,
- the PIN diode is built up in an undoped semiconductor layer of IIIN semiconductor material with lateral P, I, N regions, and
- PIN diode and field effect transistor are laterally arranged in such a manner that the undoped semiconductor layer of the diode forms an additional buffer layer of the transistor structure.

2. Integrated arrangement according to claim 1, characterised in that
- PIN diode and field effect transistor are arranged on a semi-insulating GaAs substrate (1) and a buffer layer (2), which is formed thereon, of GaAs and an AlGaAs/GaAs superlattice,
- an undoped GaAs layer (3) is formed on the buffer layer (2),
- the PIN diode is formed to be contained in the undoped GaAs layer (3) by implanted P and N contact regions (8, 9), and
- the active semiconductor layers (4, 5, 6) of the field effect transistor are arranged on the undoped GaAs layer (3), which forms an additional buffer layer for the transistor, in such a manner that the active semiconductor layers (4, 5, 6) of the transistor are obtained merely in the region of the field effect transistor.

3. Integrated arrangement according to claim 2, characterised in that the field effect transistor is formed as HFET and consists of
- an undoped InGaAs layer (4) with a layer thickness of about 12 nm,
- an undoped GaAs/AIGaAs spacer layer with a layer thickness of about 5 nm,
- a homogeneously, pulsed or delta n-doped AlGaAs layer (5) with a doping concentration of 5 x 10¹²cm⁻³ and a layer thickness of about 30 nm, and
- a homogeneous n-doped GaAs layer (6) with a doping concentration of 5 x 10¹⁸ cm⁻³ and a layer thickness of about 40 nm.

4. Integrated arrangement according to claim 2, characterised in that the field effect transistor is formed as MESFET and consists of a layer sequence of
- a homogeneous n-doped GaAs layer (4) with a doping concentration of 3 x 10¹⁷ cm⁻³ of a layer thickness of about 100 nm,
- a homogeneous n-doped GaAs layer (5) with a doping concentration of 3 x 10¹⁷ cm⁻³ and a layer thickness of 50 nm, and
- a homogeneous n-doped GaAs layer (6) with a doping concentration of 5 x 10¹⁸ cm⁻³ and a layer thickness of about 40 nm.

5. Method for the production of an integrated arrangement of PIN diode and field effect transistor according to one of the preceding claims 2, 3 and 4, characterised in that
- the buffer layer (2), the undoped GaAs layer (3) and the active semiconductor layers (4, 5, 6) of the transistor are grown on a semi-insulating substrate (1) in merely one epitaxial process,
- the active semiconductor layers (4, 5, 6) of the transistor are removed in the region of the PIN diode,
- a dielectric layer (7) is formed on the surface of the arrangement and structured in such a manner that a mask for the production of the N and P contact regions of the PIN diode is formed,
- the N and P contact regions (8, 9) are implanted in the layer (3) and subsequently a curing process is undertaken, and
- the contacts for the PIN diode and the field effect transistor are produced and at least the resistive contacts for the N conductive contact region (11) of the PIN diode are formed simultaneously with the resistive source and drain contacts (12, 14).

## Revendications

1. Dispositif intégré comprenant une diode PIN et un transistor à effet de champ, caractérisé en ce
- que le transistor à effet de champ est formé par un matériau semiconducteur III/V en tant que HFET ou MESFET,
- que la diode PIN est formée dans une couche semiconductrice non dopée formée d'un matériau semiconducteur III/V avec des régions latérales de type P, I, N, et
- que la diode PIN et le transistor FET sont disposés latéralement de telle sorte que la couche semiconductrice non dopée de la diode forme une couche tampon supplémentaire de la structure à transistor.

2. Dispositif intégré selon la revendication 1, caractérisé en ce
- que la diode PIN et le transistor à effet de champ sont disposés sur un substrat semi-isolant en GaAs (1) et sur une couche tampon (2) déposée sur le substrat et formée de GaAs avec un réseau supérieur en AlGaAs/GaAs,
- qu'une couche en GaAs non dopée (3) est déposée sur la couche tampon (2),
- que la diode PIN est formée dans la couche en GaAs non dopée (3) au moyen de régions implantées de contact de type P et N (8,9),
- que les couches semiconductrices actives (4,5,6) du transistor à effet de champ sont disposées sur la couche en GaAs dopée (3), qui forme une couche tampon supplémentaire pour le transistor, de telle sorte que les couches semiconductrices actives (4,5,6) du transistor sont réalisées uniquement dans la zone du transistor à effet de champ.

3. Dispositif intégré selon la revendication 2, caractérisé en ce que le transistor à effet de champ est agencé sous la forme d'un transistor HFET et est formé par une suite de couches comprenant :
- une couche en InGaAs non dopée (4) possédant une épaisseur d'environ 12 nm,
- une couche entretoise en GaAs/AlGaAs non dopée et possédant une épaisseur d'environ 5 nm,
- une couche en AlGaAs (5), dopée de type n de façon homogène, par impulsions ou delta et possédant une concentration de dopage de 5 x 10¹² cm⁻³ et une épaisseur d'environ 30 nm, et
- une couche homogène en GaAs (6) dopée de type n, possédant une concentration de dopage égale à 5 x 10¹⁸ cm⁻³ et une épaisseur de couche d'environ 40 nm.

4. Dispositif intégré selon la revendication 2, caractérisé en ce que le transistor à effet de champ est agencé sous la forme d'un transistor MOSFET et est formé par une suite de couches comprenant :
- une couche homogène en GaAs (4) dopée de type n, possédant une concentration de dopage égale 3 x 10¹⁷ cm⁻³ et possédant une épaisseur de 100 nm,
- une couche homogène en GaAs (5) dopée de type n, possédant une concentration de dopage de 3 x 10¹⁷ cm⁻³ et une épaisseur de 50 nm,
- une couche homogène en GaAs (6) dopée de type n, ayant une concentration de dopage de 5 x 10¹⁸ cm⁻³ et une épaisseur d'environ 40 nm.

5. Procédé pour fabriquer un dispositif intégré constitué par une diode PIN et un transistor à effet de champ selon l'une des revendications précédentes 2, 3 ou 4, caractérisé en ce
- qu'on fait croître, sur un substrat semi-isolant (1), la couche tampon (2), la couche en GaAs non dopée (3) et les couches semiconductrices actives (4,5,6) du transistor, en un seul processus d'épitaxie,
- qu'on élimine les couches semiconductrices actives (4,5,6) du transistor dans la zone de la diode PIN,
- qu'on dépose une couche diélectrique (7) sur la surface du dispositif et qu'on la structure de manière à former un masque pour la fabrication des régions de contact de type N et P de la diode PIN,
- qu'on implante les régions de contact de type N et P (8,9) dans la couche (3) et qu'on applique ensuite un procédé de recuit, et
- qu'on fabrique des contacts pour la diode PIN et le transistor à effet de champ et qu'on dépose au moins les contacts ohmiques pour la région de contact (11) conductrice de type N de la diode PIN en même temps que les contacts ohmiques de source et drain (12,14).
